Europäisches Patentamt

European Patent Office

Office européen des brevets

(19)

(11) Publication number: **0 418 500 A2**

# EUROPEAN PATENT APPLICATION

(12)

(21) Application number: **90114003.8**

(22) Date of filing: **21.07.90**

(51) Int. Cl.⁵: **H01L 27/148**

The title of the invention has been amended (Guidelines for Examination in the EPO, A-III, 7.3).

(30) Priority: **25.07.89 JP 192959/89**

(43) Date of publication of application:
**27.03.91 Bulletin 91/13**

(84) Designated Contracting States:
**DE FR GB**

(71) Applicant: **MATSUSHITA ELECTRIC INDUSTRIAL CO., LTD.**
**1006, Oaza Kadoma**
**Kadoma-shi, Osaka-fu, 571(JP)**

(72) Inventor: **Yamada, Takahiro**
**2-22-1-106, Taguchiyama**
**Hirakata-shi, Osaka-fu(JP)**
Inventor: **Terakawa, Sumio**
**5-611, Nara-cho**
**Ibaraki-shi, Osaka-fu(JP)**

(74) Representative: **Eisenführ, Speiser & Strasse**
**Martinistrasse 24**
**W-2800 Bremen 1(DE)**

(54) **Semiconductor device for charge transfer.**

(57) In a CCD device, there are defined a plurality of trench holes in the high resistivity semiconductor layer to be juxtaposed in a charge transfer direction, and charge transfer electrodes are buried in the trench holes, whereby charge transfer regions are formed in the said semiconductor layer around and the vicinity of the respective trench holes under a main operation state.

*Fig.3(b)*

## SEMICONDUCTOR DEVICE FOR CHARGE TRANSFER DEVICE

### BACKGROUND OF THE INVENTION

Field of the Invention

The present invention relates to a semiconductor device and more particularly to a structure of charge transfer device.

Description of the Prior Art

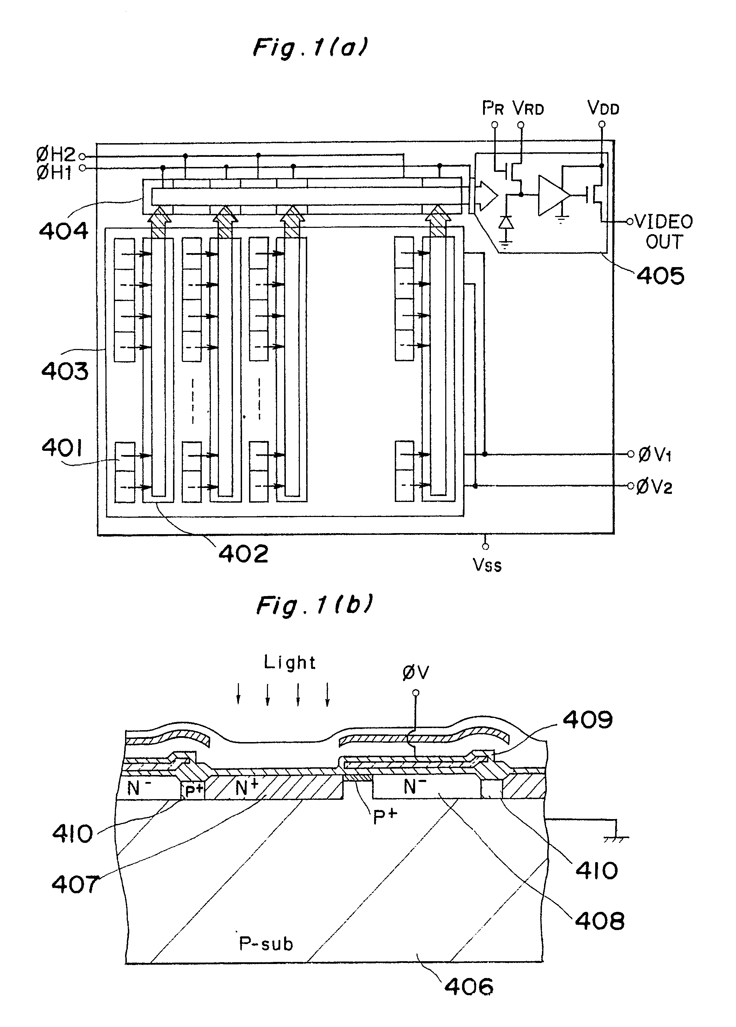

Conventional example of charge coupled type or CCD type image pick-up device is disclosed in C. H. Sequin, M. F. Tompsett "Charge Transfer Device" published by Academic Press New York, N. Y. 1975. Such C.C.D. type image pick-up device comprises, as shown in Fig. 1(a), a light receiving part 403 consisting of a photoelectric conversion region 401 and a vertical CCD region 402, a horizontal CCD part 404 and an output amplifier 405. The light receiving part 403 is shown in Fig. 1(b) in which $n^+$ region 407 formed on a surface of a P substrate 406 constitutes the phototelectric conversion region 401 of p-n junction type photodiode, while $n^-$ region 408 having high resistivity constitutes the vertical CCD region 402 in association with transferring gate electrode 409. In attempting to make the device high resolution by increasing the device density holding the size of the area of the device as it is, (that is holding the optical lens system as it is), it is necessary to divide one area of one picture element or one pixell into the photoelectric conversion region 401 and the vertical CCD region 402. Since the size occupied by the photoelectric conversion region 402 (which is called as opening rate) defines the sensitivity and the size of the vertical CCD region 402, relates to width of the charge transferring channel and defines dynamic range, there occurs trade off between sensitivity and dynamic range.

As a result of study of dissolving the above problem, the present inventors have found that it is possible to enlarge the effective channel width of the CCD device in such a manner that there constitutes a three dimensional trench 502 or recess in a form of groove in the vertical CCD region 402 as shown in Fig. 2 disclosed in the Japanese Patent Publication (unexamined) 63-12162. More specifically, an elongated trench groove 502 is formed in a substrate 501 of P conductivity type so as to extend in one direction and n conductivity region 503 acting as a buried channel region is formed on the surface of the trench groove 502, thereafter, a number of first transfer electrodes 505 are formed on the surface of the trench groove 502 which both are isolated by insulation layers 504 and a number of second transfer electrodes 507 are formed on the surface of the trench groove 502 which both are isolated by insulation layers 506. By the arrangement mentioned as above, since the area occupied by the vertical CCD region per one pixel can be decreased, the size of the phototelectric conversion region 401 can be increased, thereby resulting in improving the sensitivity of the CCD image pick-up device. In addition, in the vertical CCD unit 402, the dynamic range can be improved by increasing the effective channel width of the transfer channel by increasing the depth of the trench groove 502. (reference literature: T. YAMADA etal, "TRENCH CCD IMAGESENSOR" IEEE 1989,International Conference on Consumer Electronics, pp 178-179, June 1989).

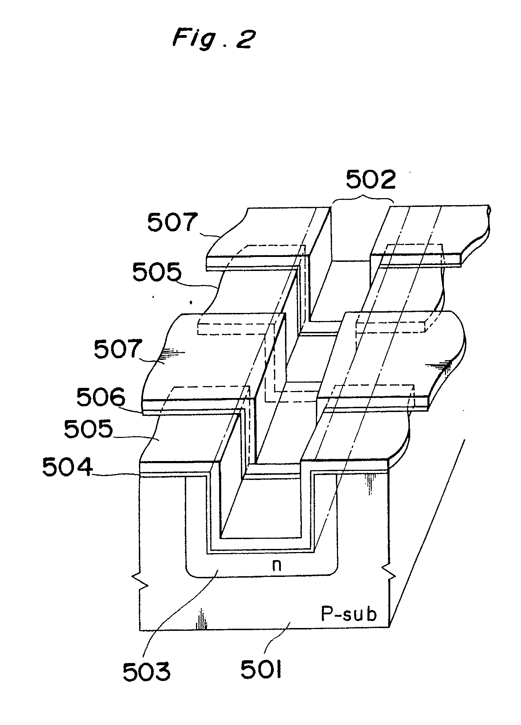

However, there is a specific problem of constituting the trench groove in the CCD device. Namely, the transfer electrodes 505 as shown in Fig. 2 are formed by processes of forming a poly silicon layer on the wall surface of the trench groove uniformly and removing unnecessary portion of the layer by etching. Difficulty of completing the transfer electrodes increases as the depth of the trench groove increases.

Because, the CCD device with the trench groove has tow kinds of transfer electrodes 505 and 507 similar to the conventional CCD device, therefore, it is necessary to repeat the etching process twice, and it is absolutely necessary to prepare protection film for proofing the damage of the semiconductor portion due to long time etching process, whereby burden required in production process is not negligible.

### SUMMARY OF THE INVENTION

An essential object of the present invention is to provide a semiconductor device having trench structure with improved sensitivity and dynamic range without poly silicon work in the trench groove.

In order to accomplish the object mentioned as above, according to the present invention there is provided a semiconductor device including CCD device comprising first charge transferring regions formed in such a manner that a plurality of trench holes are juxtaposed in the charge transferring direction and charge transferring electrodes are buried in the respective trench holes which both are isolated by insulation layers, thereby the first charge transferring region is formed on the peripheral portion of each of the trench hole and second charge transferring regions formed between the respective trench holes on the surface of the CCD device.

According to the present invention, the trench is formed in a form of juxtaposed holes, any etching process for forming charge transferring electrodes in the trench is unnecessary, whereby it becomes possible to form the electrodes independent of the depth of the trench, and enabling the structure and process of manufacturing the CCD device to be simple.

## BRIEF EXPLANATION OF THE DRAWINGS

Fig. 1(a) is a block diagram showing an example of a conventional image pick up device using CCD device,

Fig. 1(b) is a cross sectional view of an essential portion of the device shown in Fig. 1(a),

Fig. 2 is a perspective view of a part of a trench type CCD device,

Figs. 3(a) to 3(p) are related to the first embodiment of the semiconductor device according to the present invention :

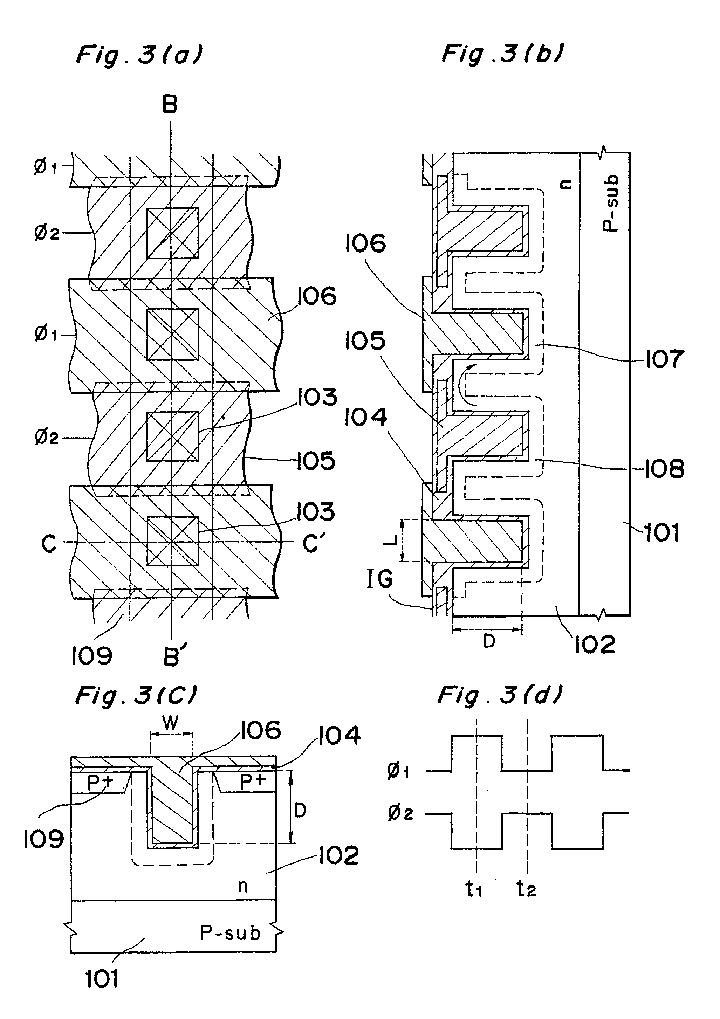

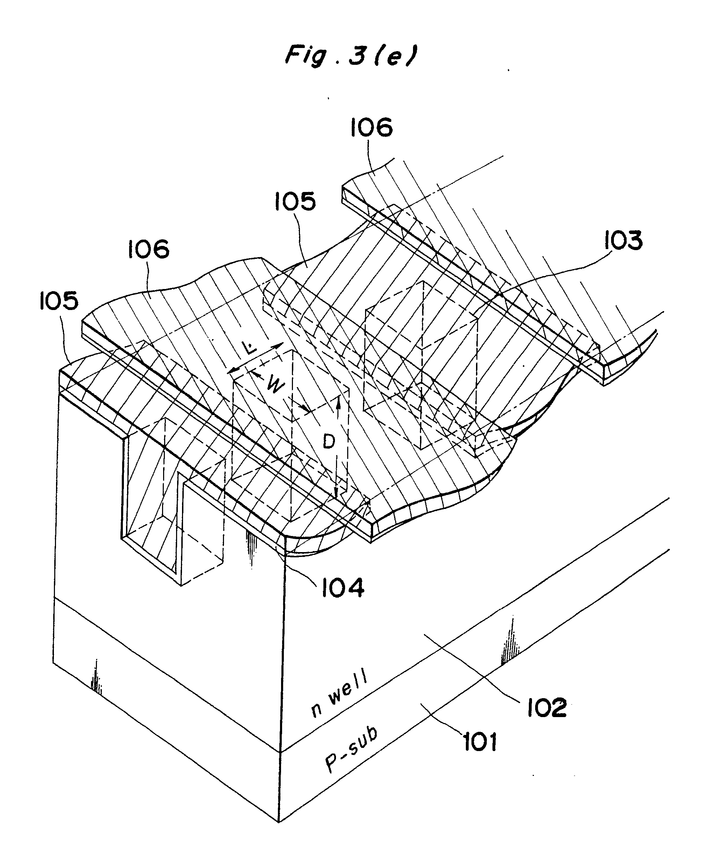

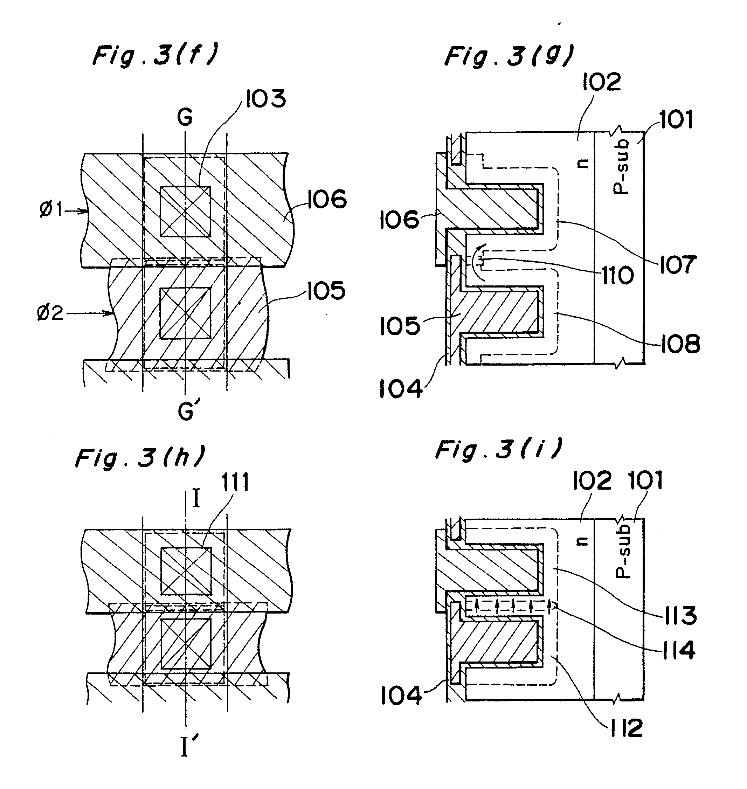

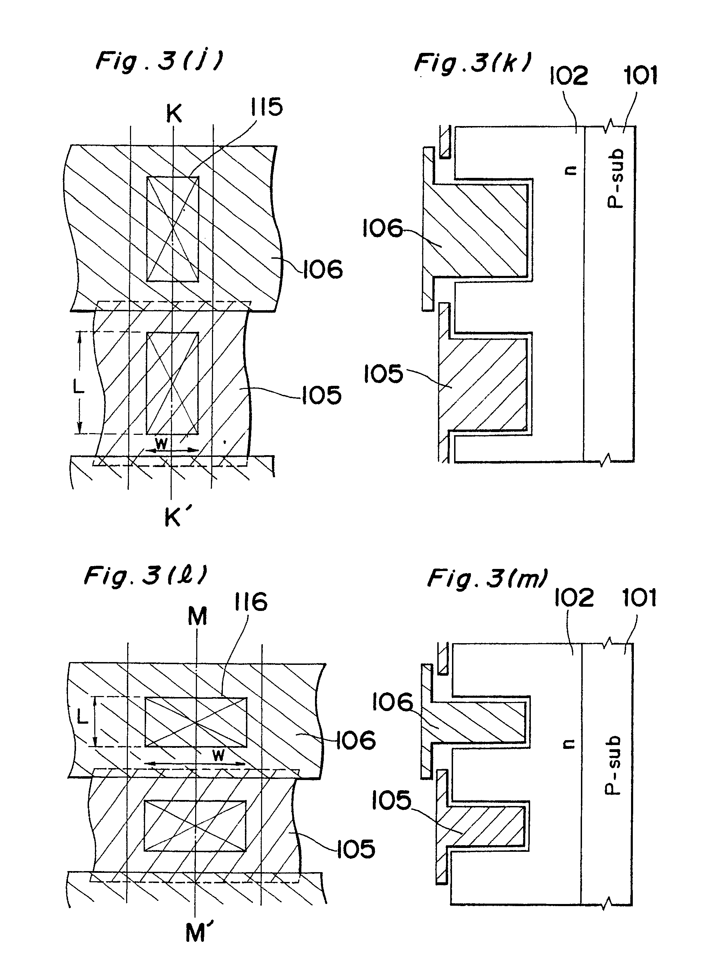

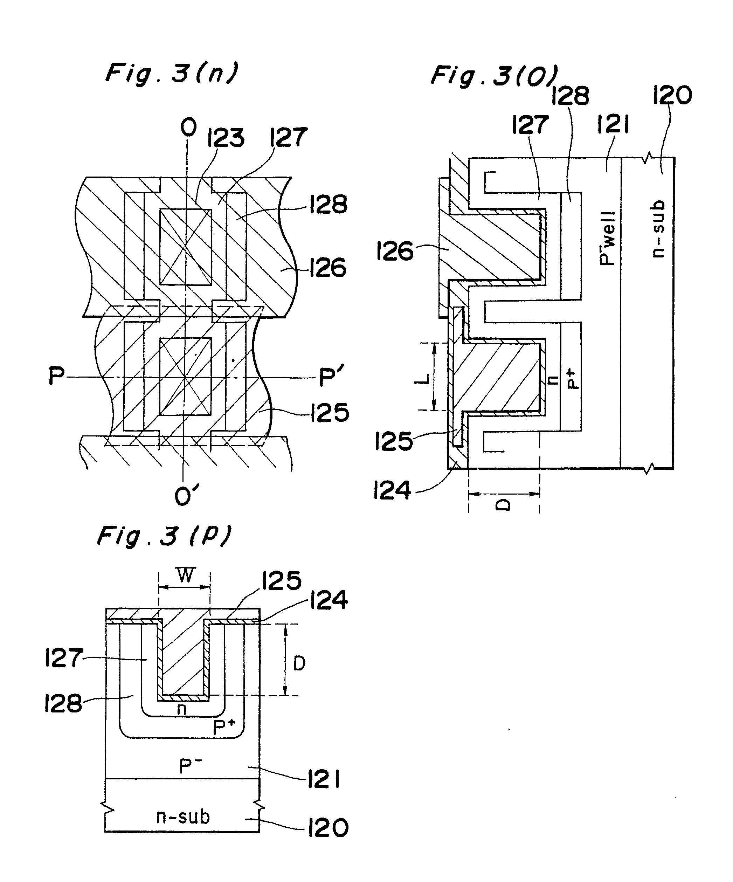

Fig. 3(a) is a plan view of the first embodiment of the CCD device according to the present invention,

Fig. 3(b) is a cross sectional view taken along the lines B-B$'$ in Fig. 3(a),

Fig. 3(c) is a cross sectional view taken along the lines C-C$'$ in Fig. 3(a),

Fig. 3(d) shows a wave form of pulses used for the device shown in Fig. 3(a),

Fig. 3(e) is a perspective view of the device shown in Fig. 3(a),

Fig. 3(f) is partial plan view of Fig. 3(a),

Fig. 3 (g) is a cross sectional view taken along the lines G-G$'$ in Fig. 3(f),

Fig. 3(h) is a partial plan view of a modification of the embodiment shown in Fig. 3(a),

Fig. 3(i) is a cross sectional view taken along the lines I-I$'$ in Fig. 3(h),

Fig. 3(j) is a plan view of a modification of the embodiment shown in Fig. 3(a),

Fig. 3(k) is a cross sectional view taken along the lines K-K$'$ in Fig. 3(j),

Fig. 3(ℓ) is a plan view of a modification of the embodiment shown in Fig. 3(a),

Fig. 3(m) is a cross sectional view taken along the lines M-M$'$ in Fig. 3(ℓ),

Fig. 3(n) is a plan view of a modification of the embodiment shown in Fig. 3(a),

Fig. 3(o) is a cross sectional view taken along the lines O-O$'$ in Fig. 3(n),

Fig. 3(p) is a cross sectional view taken along the lines P-P$'$ in Fig. 3(n),

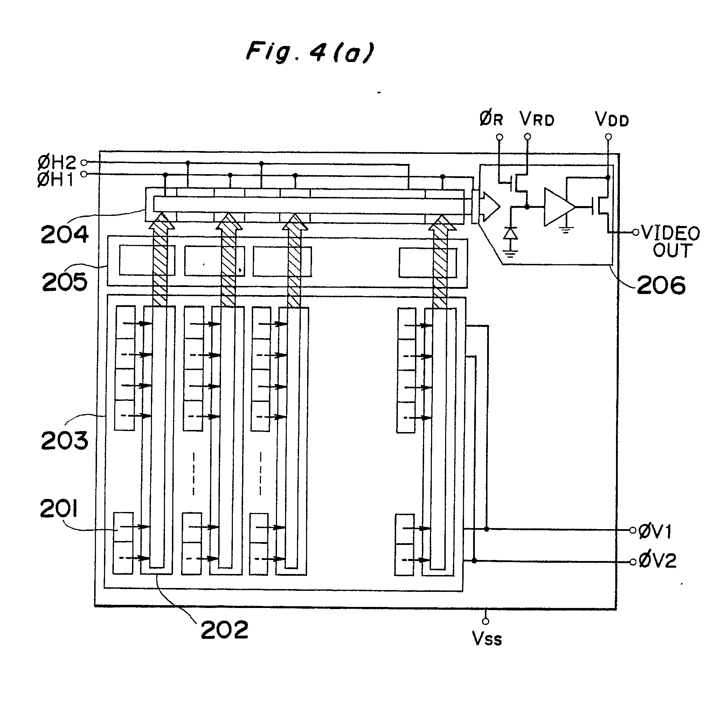

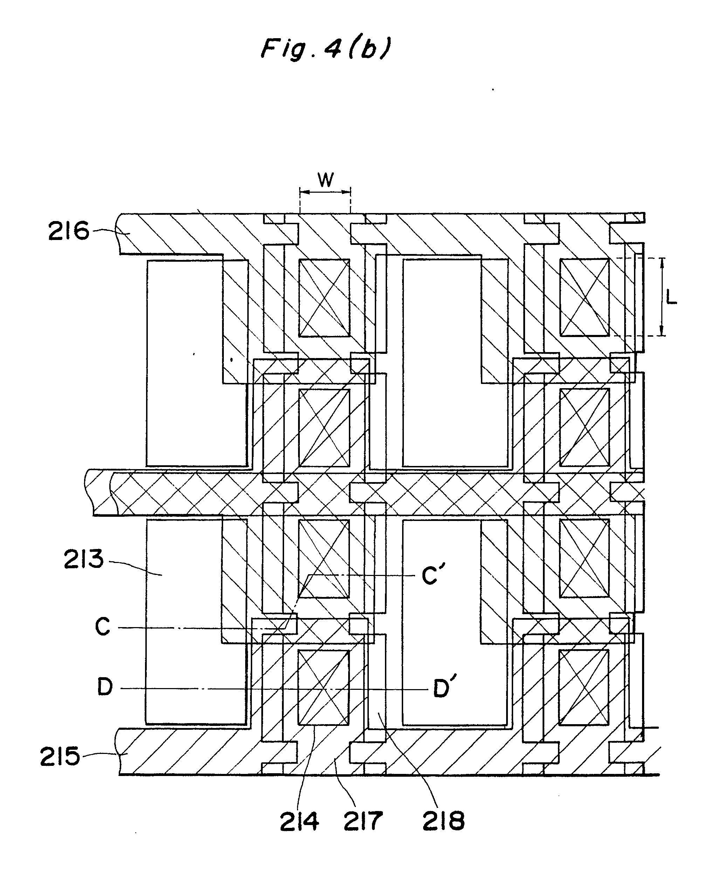

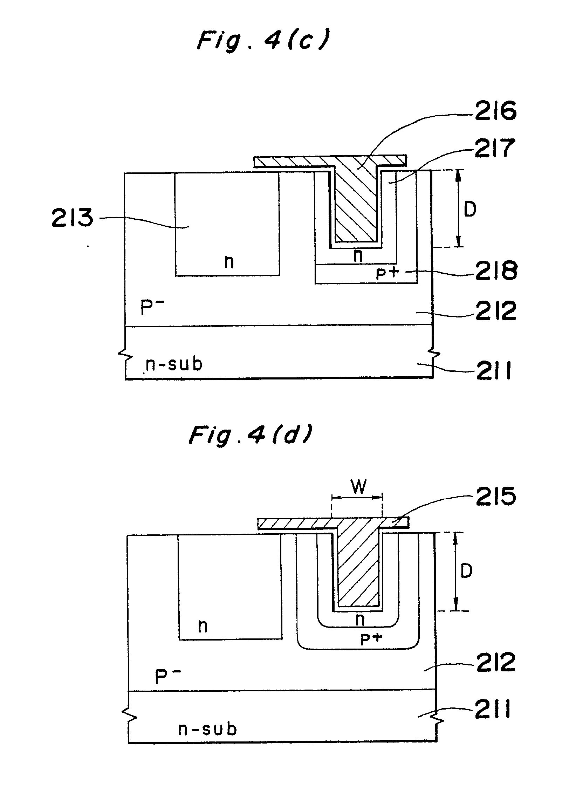

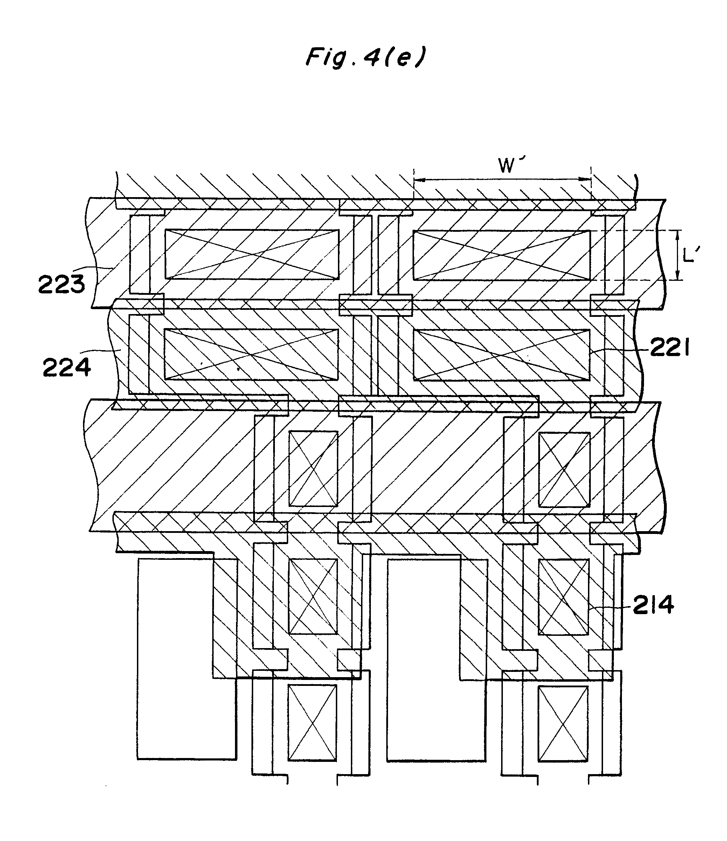

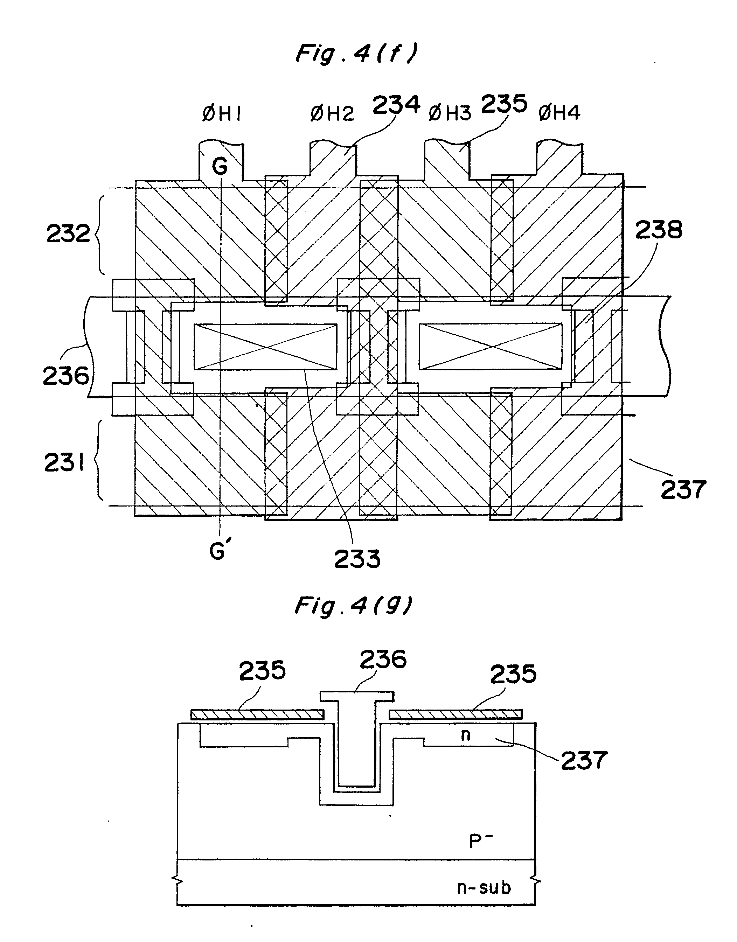

Figs. 4(a) to 4(f) show a further embodiment of the image pick up device according to the present invention:

Fig. 4(a) is a block diagram of the image pick up device according to the present invention,

Fig. 4(b) is a plan view of the light receiving part in Fig. 4(a),

Fig. 4(c) is a cross sectional view taken along the lines C-C$'$ in Fig. 4(b),

Fig. 4(d) is a cross sectional view taken along the lines D-D$'$ in Fig. 4(b),

Fig. 4(e) is a plan view from the light receiving part to the charge storing part in Fig. 4(a),

Fig. 4(f) is a plan view of the 2 channel horizontal CCD device,

Fig. 4(g) is a cross sectional view taken along the lines G-G$'$ in Fig. 4(f),

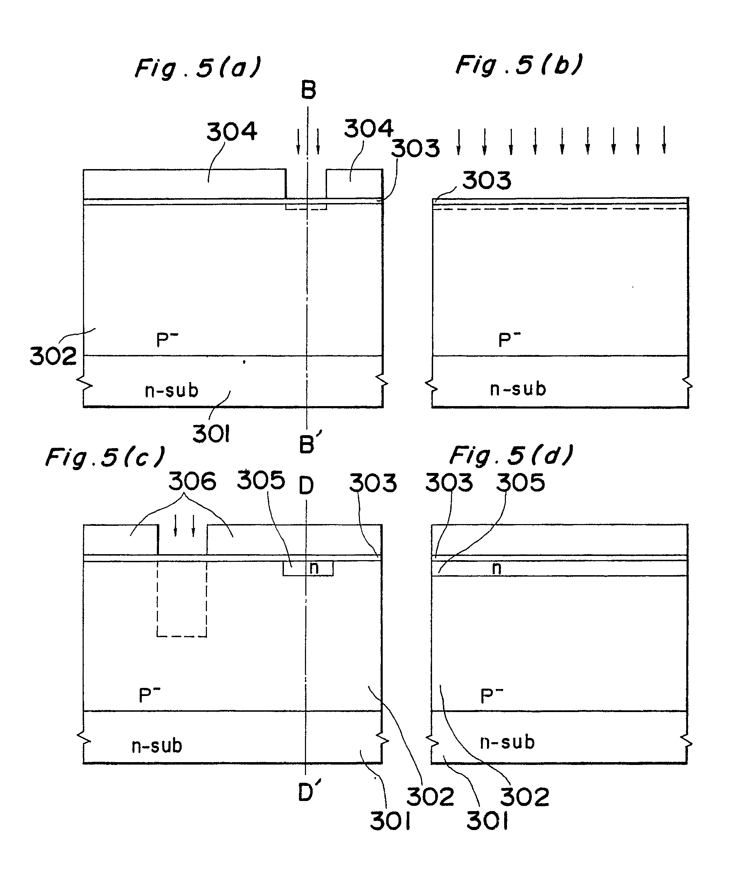

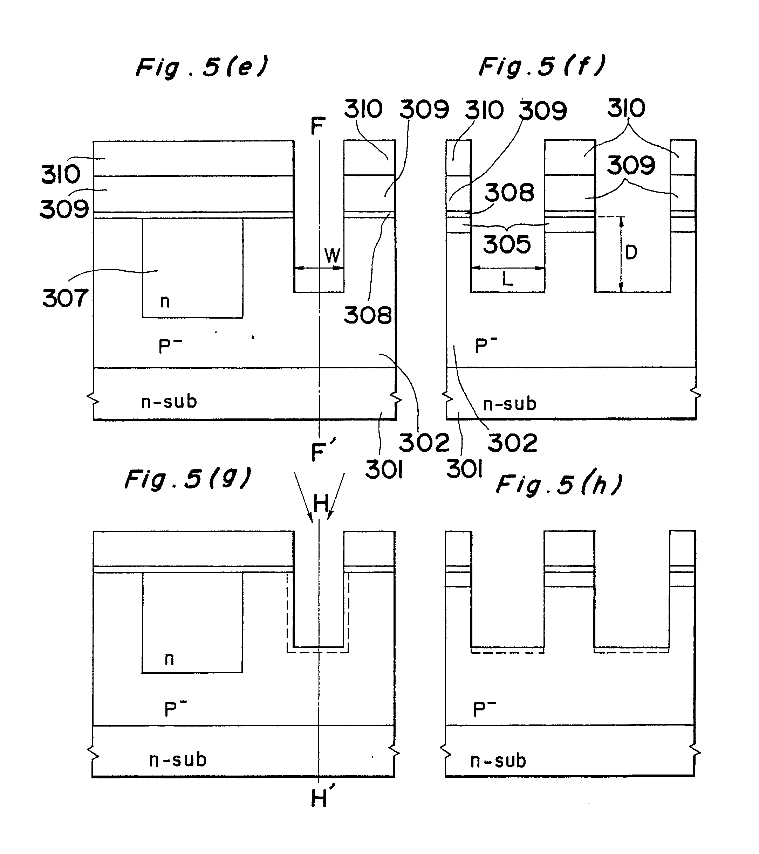

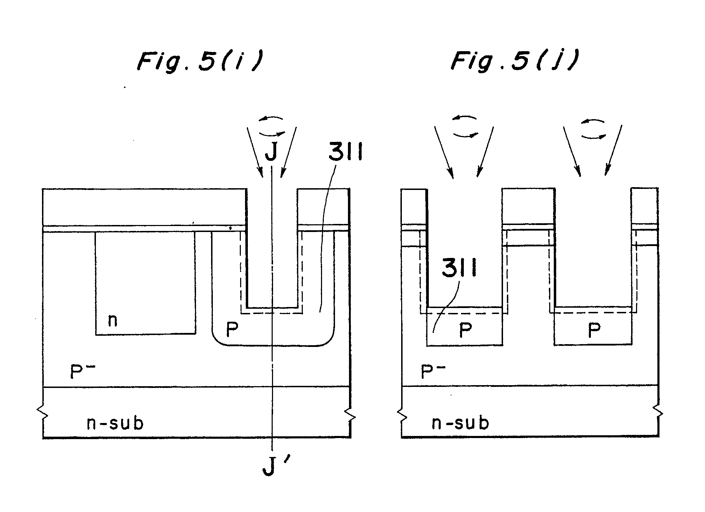

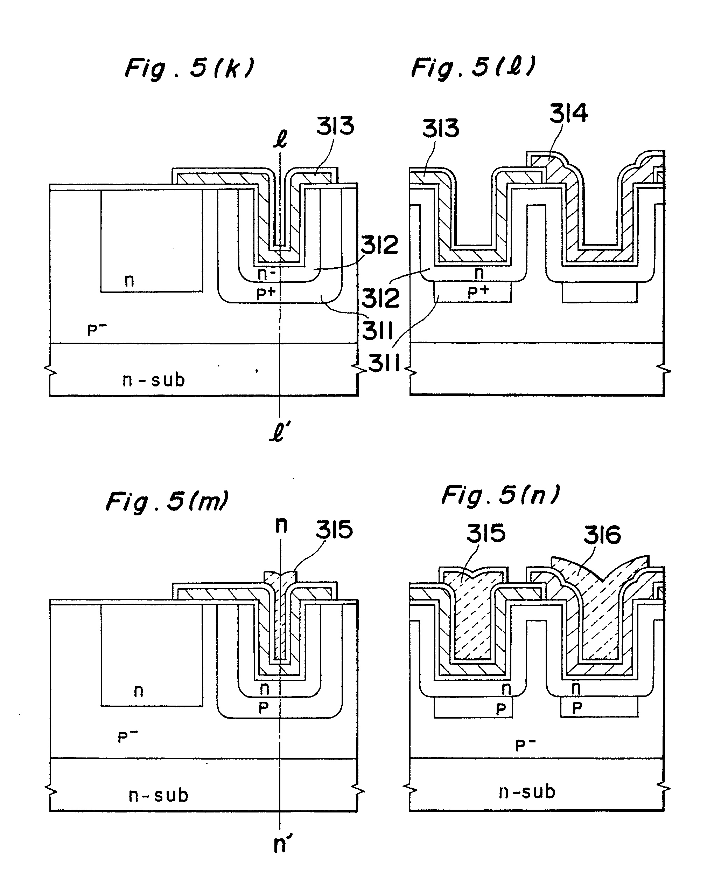

Figs. 5(a) to 5(n) are cross sectional view showing the production processes of the device shown in Fig. 4.

## DETAILED DESCRIPTION OF THE PREFERRED EMBODIMENTS

Referring to Fig. 3(a) to Fig. 3(e), there is shown a substrate 101 of p conductivity type semiconductor on which a high resistivity region 102 of n conductivity type is formed. A plurality of holes 103 (referred to as trench hole hereinafter) are defined in the high resistivity region 102 from the surface thereof with length L, width W and depth D. It is noted that the opening window of the hole defined by L and W is referred to as an aperture and the sizes L and w are referred to as aperture size. There are formed a plurality of first electrodes 105 and a plurality of second electrodes 106 which both are isolated by insulation films 104. Each of the electrodes 105 and 106 is made of polysilicon which is buried in the trenches holes 103. Reference numerals 107 and 108 show charge transfer channels which are developed in the high resistivity region 102 around the trench holes 103 under a main operating condition, which means such a condition that necessary voltages are applied to the device so that the device shown in the drawings can act as a CCD device.

Operation of the semiconductor device constructed as described above is explained.

Two phase drive pulses $\phi 1$ and $\phi 2$ of complementary phase as shown in Fig. 3(d) are applied to the first electrodes 105 and the second electrode 106, whereby when the pulses $\phi 1$ and $\phi 2$ shift with the time shifting from t1 to t2, the signal charge is transferred in a direction from the charge transfer channel 108 to the charge transfer channel 107 as shown in an arrow mark. By repeating this operation, the charge transfer can be performed in the direction which the trench holes 103 are arranged.

A specific example of the CCD device according to the present invention is shown in Fig. 3(e), it is shown that only one kind of polysilicon electrodes are buried in the trench hole 103.

According to the embodiment mentioned as above, there are arranged the trench holes 103 in the direction of transfer of the charge, making the respective electrodes buried in the trench holes 103 as the charge transfer electrodes, whereby it is possible to realize a device structure and production process which are independent of the depth of the trench holes formed around the trench holes 103. As the result, it becomes possible to freely select the depth of the trench hole which defines the dynamic range of the charge transfer channel, thereby enabling the design work of the CCD device easy.

There may be employed various modifications and changes in the structure and operation from the embodiment described above without departing from the technical scope of the present invention.

Referring to Figs. 3(f) and 3(g), which are derived from Figs. 3(a) and 3(b), the charge transfer is made through connection parts 110 of the adjacent charge transfer channels as shown by an arrow mark. On the other hand, when the distance between the two adjacent trench holes 111 is small as shown in Figs. 1(h) and 1(i), charge transfer may be made through the transfer channels 112 and 113, whereby surface charge transfer can be performed through the wider channel 114 as shown in arrow marks.

In the example shown in Figs. 3(j) and 3(k) depicting such a case that the size L of the window of the trench hole 115 is larger than the size W.

Figs. 3(1) and 3(m) depict such a case that the size L of window of the trench hole 116 is smaller than the size W.

Figs. 3(n), 3(o), 3(p) show a further modification in which the trench holes 123 are formed in the semiconductor region 121 of which conductivity type is reversed to the conductivity type of the semiconductor region for the trench holes 103 in the example shown in Figs. 3(a), 3(b), 3(c). In Figs. 3(n), 3(o), 3(p), there is formed the P conductivity type semiconductor region 121 of a high resistivity region on a n conductivity type semiconductor substrate 120 and each trench hole 123 defined in the high resistivity region 121 from the surface thereof with the size L and W and first and second electrodes 125 and 126 made of polysilicon are formed in the trench holes 123 through an insulation film 124.

A n conductivity type high resistivity region 127 is formed in the high resistivity region 121 around each trench hole 123, in addition, outside the region 127 a low resistivity region 128 of p + conductivity is formed as a channel stop.

Referring to Fig. 4(a) showing a structure of an embodiment of the image pick up device according to the present invention, there are provided a light receiving region 203 comprising a photoelectric conversion region 201 and a vertical CCD region 202, a horizontal CCD part 204, a charge storing part 205 used as the vertical to horizontal conversion part and an output amplifier 206. The CCD device having the charge storing part is called FIT type CCD device (frame interline transfer type CCD device).

In Figs. 4(b), 4(c) and 4(d), there is formed a photoelectric conversion region 201 by a pn junction photo diode formed on a n conductivity type region 213 on the surface of the p-conductivity region 212. The vertical CCD 302 is provided by the trench hole type CCD shown in Fig. 3(n), 3(o), 3(p). In Figs. 4(b), 4(c) and 4(d), the vertical CCD region 302 is formed in such a manner that a plurality of trench holes 214 are juxtaposed in the charge transfer direction with sizes L, W and the depth D and there are formed first electrodes 215 and second electrodes 216 of polysilicon, by burying polysilicon in the respective trench holes 214. A n conductivity type region 217 used as the charge transfer channel is formed around each trench hole and the outside region, p + conductivity type region 218 is formed as the channel stop.

Figs. 4(f) and 4(g) show the structure of the 2 channel horizontal CCDs in which there is formed a trench hole 233 for transferring the charge between the first horizontal CCD region 231 and the second horizontal CCD region 232.

As the charge transfer region around the horizontal CCD and the vicinity of the trench hole there is formed n conductivity region 237 and as the channel stop region, there is formed p + conductivity type region 238. Moreover, as the charge transfer electrodes for the first and second horizontal CCDs 231 and 232, there are formed a first electrode 234 and a second electrode 235 each made of polysilicon. A third electrode 236 made of polysilicon is formed as the charge transfer electrode of the trench hole type charge transfer gate for coupling the first horizontal CCD region 231 and second horizontal CCD region 232.

The operation of the trench hole type charge transfer unit of the present embodiment is the same as the operation of the embodiment shown in Figs. 3(a) to 3(p).

According to the present embodiment it becomes possible to provide CCD device independent of the depth of the trench since any electrode working in the recess of the conventional trench groove type CCD is unnecessary by employing the trench hole type CCD in the vertical CCD region.

Figs. 5(a) to 5(k) show the production method of the semiconductor device shown in Figs. 4(a) to 4(g). The process of the making the device is sequentially explained.

(1) As shown in Figs. 5(a) and 5(b) after a protection oxide film 303 is formed on the surface of the p- type conductivity region 302 on the n conductivity type substrate 301, resist layers 304 are formed for forming a region for coupling the charge transfer regions, and n conductivity type impurities are ion injected.

(2) After the ion implantation, by performing heat processing the n conductivity type region 305 is formed as shown in Fig. 5(c) and 5(d). Thereafter resist layers 306 are formed for forming a photodiode and n conductivity type impurities are ion injected.

(3) By the heat processing after the ion implantation the n conductivity type region 307 of the photodiode is formed as shown in Figs. 5(e) and 5(f). Thereafter once the oxide film is removed and in turn nitride film 308 and PSG film 309 are formed in turn the resist 310 is formed, whereby apart of the nitride film 308 and apart of the PSG film 309 are removed. Then silicon is etched to form the trench hole of the sizes L and W and the depth D.

(4) As shown in Figs. 5(g) and 5(h), p conductivity type, impurities are ion implanted to the trench hole in the opposite directions each perpendicular to the charge transfer direction.

(5) By performing a heat processing after the ion implantation, as shown in Figs. 5(i) and 5(j) the p + conductivity type region 311 acting as the channel stop region is formed. Thereafter n conductivity type impurities are ion injected to the inside of the trench hole in a rotating slanted manner.

(6) By performing a heat processing after the ion implantation, as shown in Figs. 5(k) and 5($\ell$) the n conductivity type region 302 acting as the charge transfer region is formed. Then the gate oxide film of three layer structure $(SiO_2/Si_3N_4/SixNyOz)$ are formed on the inner surface of the trench hole, thereafter there is grown the first polysilicon electrode 215, thereafter the surface except for the trench hole is etched using the resist to form the first transfer electrode 313. In a similar manner the second transfer electrode 314 is formed.

As shown in Figs. 5(m) and 5(n), it is important for the practical use to conduct the respective processes mentioned above during forming the electrodes 313, 314 considering burying polysilicon layers 315, 316 in the trench holes.

By the production processes mentioned above, it is possible to provide CCD devices having the trench holes without any works of the electrodes in the trench holes.

Although the trench holes disclosed in the embodiments are rectangular shape in plane view with the sizes La and W, there may be formed desired shape such as circular shapes, oblong shape and any polygon shape. Moreover, the trench hole may be any reversed conical shape in place of elongated cubic shape.

The charge transfer region around and the vicinity of the trench hole may be formed by solid phase diffusion or vapor phase diffusion in place of the slanted ion implantation process of the impurities.

As mentioned above, according to present invention, there are arranged a plurality of trench holes in the substrate in the charge transfer direction and one kind of the charge transfer electrode is provided in a form of electrode in a form of electrode buried in the trench hole, there may be provided semiconductor device independent of the depth of the trench hole. In addition, by realizing the manufacturing process without bearing any load in the process, whereby it is possible to select the depth of the trench hole which defines the dynamic range property of the charge transfer.

## Claims

1. A semiconductor device comprising a high resistivity semiconductor layer, a plurality of trench holes defined in the high resistivity semiconductor layer to be juxtaposed in a charge transfer direction, and charge transfer electrodes buried in the trench holes through insulation layers whereby charge transfer regions are formed in the said semiconductor layer around and the vicinity of the respective trench holes under a main operation state.

2. A semiconductor device which comprises a semiconductor layer of first conductivity type, a plurality of trenches in the form of hole arranged in said semiconductor layer to be juxtaposed in a charge transfer direction, a high resistivity region of second conductivity type formed around and in the vicinity of each of said trench holes, in said semiconductor layer, a low resistivity layer made of the first conductivity type semiconductor for covering a region which exists between tow adjacent trench holes but is not coupled by the high resistivity region.

3. A semiconductor device comprising a photoelectric conversion region, a read out gate region, a vertical CCD region, a vertical horizontal conversion region, a horizontal CCD region, and a signal output region, characterized in the at least any one of the vertical CCD region, the horizontal CCD region and the vertical horizontal conversion region is provided with trench holes having a charge transfer region formed around the holes.

4. A semiconductor device comprising a first CCD region, a second CCD region disposed in parallel to the first CCD region and a charge transfer gate region disposed in both of the first and second CCD regions characterized in that said charge transfer gate region is provided with trench holes having a charge transfer region formed around the holes.

## Fig .1(a)

## Fig .1(b)

## Fig.2

502

507

505

507

506

505

504

n

P-sub

503   501

## Fig. 3 (a)

## Fig. 3 (b)

## Fig. 3 (C)

## Fig. 3 (d)

# Fig. 3 (e)

*Fig. 3(f)*

*Fig. 3(g)*

*Fig. 3(h)*

*Fig. 3(i)*

## Fig. 3(j)

## Fig. 3(k)

## Fig. 3(l)

## Fig. 3(m)

Fig. 3(n)

Fig. 3(O)

Fig. 3(P)

# Fig. 4 (a)

## Fig. 4(b)

## Fig. 4 (c)

## Fig. 4 (d)

## Fig. 4(e)

## Fig. 4(f)

## Fig. 4(g)

EP 0 418 500 A2

Fig.5(a)

Fig.5(b)

Fig.5(c)

Fig.5(d)

# Fig . 5 (e)

# Fig . 5 (f)

# Fig . 5 (g)

# Fig . 5 (h)

Fig. 5 (i)

Fig. 5 (j)

## Fig. 5(k)

313
312
312
311
311

n
ℓ
ℓ'
n⁻
P⁺
P⁻
n - sub

## Fig. 5(ℓ)

313
314

n
P⁺
n - sub

## Fig. 5(m)

n
315

n
n
P
P⁻
n - sub
n'

## Fig. 5(n)

315
316

n
n
P
P
P⁻
n - sub